# EUROPEAN PATENT APPLICATION

(11) **EP 4 761 514 A2**
(43) Date of publication of application: **17.06.2026**
(21) Application number: 25220167.8
(22) Date of filing: 02.12.2025
(51) Int. Cl.: H10D 84/01, H10D 30/47, H10D 62/80, H10D 64/60, H10D 84/83, H10D 84/85, H10D 88/00, H10D 30/01

(54) **SEMICONDUCTOR DEVICE AND ELECTRONIC APPARATUS INCLUDING THE SEMICONDUCTOR DEVICE**

(30) Priority: 10.12.2024 KR 20240182977
(71) Applicant: Samsung Electronics Co., Ltd., Suwon-si, Gyeonggi-do 16677 (KR)
(72) Inventor: Kim, Sangwon, 16678 Suwon-si, Gyeonggi-do (KR); Kim, Joonseok, 16678 Suwon-si, Gyeonggi-do (KR); Lee, Changseok, 16678 Suwon-si, Gyeonggi-do (KR); Kwon, Junyoung, 16678 Suwon-si, Gyeonggi-do (KR); Ryu, Huije, 16678 Suwon-si, Gyeonggi-do (KR)
(74) Representative: Grünecker Patent- und Rechtsanwälte PartG mbB

(57) **Abstract**

Provided are a semiconductor device and an electronic apparatus including the semiconductor device. The semiconductor device includes first and second transistors. The first transistor includes a first channel layer including a first transition metal dichalcogenide (TMD) material, and a first source electrode and a first drain electrode that are on the first channel layer. The second transistor is disposed below the first transistor. The second transistor includes a second channel layer including a second TMD material, and a second source electrode and a second drain electrode that are on the second channel layer. Each of the first source electrode and the first drain electrode includes a first topological metal including at least one element included in the first TMD material. Each of the second source electrode and the second drain electrode includes a second topological metal including at least one element included in the second TMD material.

## Description

### BACKGROUND

### 1. Field

This disclosure relates to semiconductor devices and electronic apparatuses including the semiconductor device.

### 2. Description of the Related Art

With the miniaturization of transistors, not only semiconductor channels but also metal portions forming elements such as electrodes, via layers, and interconnect layers have been miniaturized. This results in an increase in the influence of metal surfaces and/or grain boundaries on charge transfer, potentially causing issues such as voltage drop (IR drop). In addition, as transistor miniaturization progresses, a complementary field-effect transistor (CFET) structure has been proposed to reduce or minimize the area of complementary metal-oxide semiconductor (CMOS) transistors by vertically stacking n-channel metal-oxide semiconductor (NMOS) transistors and p-channel metal-oxide semiconductor (PMOS) transistors.

### SUMMARY

Some example embodiments of the disclosure provide semiconductor devices and electronic apparatuses including the semiconductor device.

The invention is what is claimed in the independent claims. Preferred embodiments are specified in the dependent claims.

Additional aspects will be set forth in part in the description which follows, and in part, will be apparent from the description, or may be learned by practice of the presented example embodiments of the disclosure.

According to an example embodiment of the disclosure, a semiconductor device includes a first transistor including a first channel layer, a first source electrode, and a first drain electrode, the first channel layer including a first transition metal dichalcogenide (TMD) material, the first source electrode and the first drain electrode being on the first channel layer, and a second transistor below the first transistor, the second transistor including a second channel layer, a second source electrode, and a second drain electrode, the second channel layer including a second TMD material, the second source electrode and the second drain electrode being on the second channel layer, wherein each of the first source electrode and the first drain electrode includes a first topological metal including at least one element included in the first TMD material, and each of the second source electrode and the second drain electrode includes a second topological metal including at least one element included in the second TMD material.

The first source electrode and the second source electrode may be connected to each other in a vertical direction.

The first drain electrode and the second drain electrode may be connected to each other in a vertical direction.

The first source electrode and the first drain electrode may be on both sides of the first channel layer, respectively, and the second source electrode and the second drain electrode may be on both sides of the second channel layer, respectively.

Each of the first source electrode and the first drain electrode may include a first interface layer and a first metal layer. The first interface layer may be in contact with a lateral surface of the first channel layer and may include the first topological metal. The first metal layer may be on the first interface layer. Each of the second source electrode and the second drain electrode may include a second interface layer and a second metal layer. The second interface layer may be in contact with a lateral surface of the second channel layer and may include the second topological metal. The second metal layer may be on the second interface layer.

The first source electrode and the first drain electrode may be above both sides of the first channel layer, respectively, and the second source electrode and the second drain electrode may be below both sides of the second channel layer, respectively.

Each of the first source electrode and the first drain electrode may include a first interface layer and a first metal layer. The first interface layer may be in contact with an upper surface of a side of the first channel layer and may include the first topological metal. The first metal layer may be on the first interface layer. Each of the second source electrode and the second drain electrode may include a second interface layer and a second metal layer. The second interface layer may be in contact with a lower surface of a side of the second channel layer and may include the second topological metal. The second metal layer may be on the second interface layer.

The semiconductor device may further include a first via layer electrically connected to each of the first source electrode and the first drain electrode, and a second via layer electrically connected to each of the second source electrode and the second drain electrode.

The first via layer may include the first topological metal, and the second via layer may include the second topological metal.

The semiconductor device may further include a first interconnect layer electrically connected to the first via layer, and a second interconnect layer electrically connected to the second via layer.

The first interconnect layer may include the first topological metal, and the second interconnect layer may include the second topological metal.

The first transistor may be a p-channel metal-oxide semiconductor (PMOS) transistor, and the second transistor may be an n-channel metal-oxide semiconductor (NMOS) transistor.

Each of the first and second transistors may be a PMOS transistor.

Each of the first and second transistors may be an NMOS transistor.

The semiconductor device may further include a third transistor below the second transistor, the second transistor including a third channel layer, a third source electrode, and a third drain electrode. The third channel layer may include a third TMD material, and the third source electrode and the third drain electrode may be on the third channel layer. Each of the third source electrode and the third drain electrode may include a third topological metal including at least one element included in the third TMD material.

An insulating layer may be between the first channel layer and the second channel layer.

The semiconductor device may further include a gate electrode inside the insulating layer.

The first channel layer may include a plurality of first sub-channel layers provided apart from each other, the second channel layer may include a plurality of second sub-channel layers provided apart from each other, and a gate electrode may surround the plurality of first sub-channel layers and the plurality of second sub-channel layers.

The first source electrode and the first drain electrode may be below and above the first channel layer, respectively, and the second source electrode and the second drain electrode may be above and below the second channel layer, respectively.

According to an example embodiment of the disclosure, an electronic apparatus includes a plurality of semiconductor devices, each of the plurality of semiconductor devices comprising a first transistor including a first channel layer, a first source electrode, and a first drain electrode, the first channel layer including a first transition metal dichalcogenide (TMD) material, the first source electrode and the first drain electrode being on the first channel layer, and a second transistor disposed below the first transistor and including a second channel layer, a second source electrode, and a second drain electrode, the second channel layer including a second TMD material, the second source electrode and the second drain electrode being on the second channel layer, wherein each of the first source electrode and the first drain electrode includes a first topological metal including at least one element included in the first TMD material, and each of the second source electrode and the second drain electrode includes a second topological metal including at least one element included in the second TMD material.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a cross-sectional view illustrating a semiconductor device according to an example embodiment;
FIG. 2 is a cross-sectional view illustrating a semiconductor device according to an example embodiment;
FIG. 3 is a cross-sectional view illustrating a semiconductor device according to an example embodiment;
FIGS. 4A to 4C are views illustrating a method of manufacturing the semiconductor device shown in FIG. 3, according to an example embodiment;
FIG. 5 is a cross-sectional view illustrating a semiconductor device according to an example embodiment;
FIG. 6 is a cross-sectional view illustrating a semiconductor device according to an example embodiment;
FIG. 7 is a cross-sectional view illustrating a semiconductor device according to an example embodiment;
FIG. 8 is a cross-sectional view illustrating a semiconductor device according to an example embodiment;
FIG. 9 is a cross-sectional view illustrating a semiconductor device according to an example embodiment;
FIG. 10 is a cross-sectional view illustrating a semiconductor device according to an example embodiment;
FIG. 11 is a cross-sectional view illustrating a semiconductor device according to another embodiment;
FIG. 12 is a cross-sectional view illustrating a semiconductor device according to an example embodiment;
FIG. 13 is a cross-sectional view illustrating a semiconductor device according to an example embodiment; and
FIG. 14 is a cross-sectional view illustrating a semiconductor device according to an example embodiment.

### DETAILED DESCRIPTION

Reference will now be made in detail to example embodiments, examples of which are illustrated in the accompanying drawings, wherein like reference numerals refer to like elements throughout. In this regard, the present example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "one of," "one or more of," "any one of," and "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

Hereinafter, some example embodiments will be described with reference to the accompanying drawings. In the drawings, like reference numerals refer to like elements, and the sizes of elements may be exaggerated for clarity of illustration. The example embodiments described herein are for illustrative purposes only, and various modifications may be made therein.

In the following description, when an element is referred to as being "above" or "on" another element, it may be directly on an upper, lower, left, or right side of the other element while making contact with the other element or may be above an upper, lower, left, or right side of the other element without making contact with the other element. The terms of a singular form may include plural forms unless otherwise mentioned. It will be further understood that the terms "comprises" and/or "comprising" used herein specify the presence of stated features or elements, but do not preclude the presence or addition of one or more other features or elements.

An element referred to with the definite article or a demonstrative determiner may be construed as the element or the elements even though it has a singular form. Operations of a method may be performed in an appropriate order unless explicitly described in terms of order or described to the contrary, and are not limited to the stated order thereof.

In the present specification, terms such as "unit" or "module" may be used to denote a unit that has at least one function or operation and is implemented with hardware, software, or a combination of hardware and software.

Furthermore, line connections or connection members between elements depicted in the drawings represent functional connections and/or physical or circuit connections by way of example, and in actual applications, they may be replaced or embodied with various additional functional connections, physical connections, or circuit connections.

Examples or terms are just used herein to describe technical ideas and should not be considered for purposes of limitation unless defined by the claims.

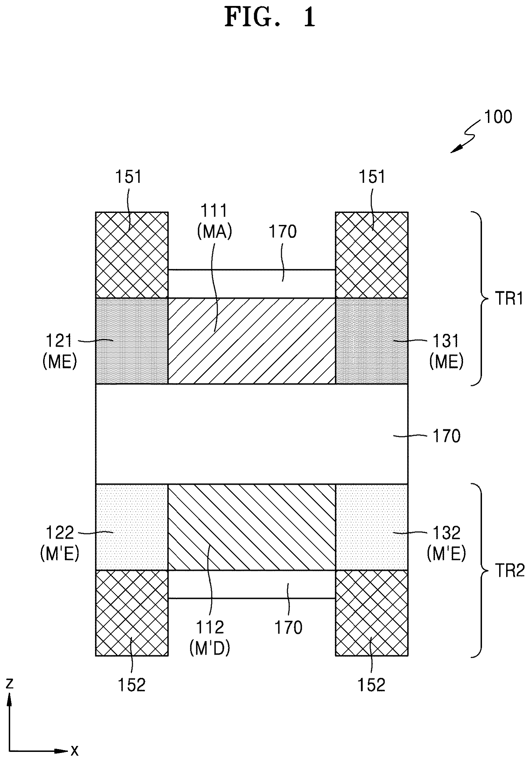

FIG. 1 is a cross-sectional view illustrating a semiconductor device 100 according to an example embodiment.

Referring to FIG. 1, the semiconductor device 100 includes a first transistor TR1 and a second transistor TR2 that are stacked apart from each other in a vertical direction (z-axis direction). An insulating layer 170 may be provided between the first transistor TR1 and the second transistor TR2. The first transistor TR1 may be, for example, a p-channel metal-oxide semiconductor (PMOS) transistor, and the second transistor TR2 may be, for example, an n-channel metal-oxide semiconductor (NMOS) transistor. The first and second transistors TR1 and TR2 may be arranged symmetrically in the vertical direction with respect to the insulating layer 170.

The first transistor TR1 includes a first channel layer 111, and a first source electrode 131 and a first drain electrode 121 that are provided on both sides of the first channel layer 111, respectively. Here, the first source electrode 131 and the first drain electrode 121 may be in contact with lateral surfaces of the first channel layer 111, respectively.

The first channel layer 111 may include a semiconductor compound of a first conductive type. For example, the first channel layer 111 may include a two-dimensional semiconductor material of the first conductive type. For example, the first channel layer 111 may include a first transition metal dichalcogenide (TMD) material.

The term "two-dimensional semiconductor material" refers to a material that has a layered structure in which constituent atoms are two-dimensionally bonded to each other and exhibit semiconductor properties. Such a two-dimensional semiconductor material exhibits electrical properties and may maintain relatively high mobility without significant changes in its characteristics even when its thickness is reduced to the nanoscale. The term "TMD material" refers to a two-dimensional semiconductor material that is a compound of a transition metal and a chalcogen element. Here, the transition metal may include at least one selected from Mo, W, Nb, V, Ta, Ti, Zr, Hf, Co, Tc, Re, and Pt, and the chalcogen element may include at least one selected from S, Se, and Te. For example, the TMD material may include MoS₂, MoSe₂, MoTe₂, WS₂, WSe₂, WTe₂, ZrS₂, ZrSe₂, HfS₂, HfSe₂, NbSe₂, ReSe₂, PtS₂, TaS₂, PtSe₂, PtTe₂, MoSSe, MoWS₂, or the like However, example embodiments are not limited thereto.

The first channel layer 111 may include the first TMD material. For example, the first TMD material may include a p-type TMD material. The p-type TMD material may include, for example, MoS₂, MoSe₂, MoSSe, MoWS₂, WS₂, WSe₂, PtS₂, TaS₂, or the like However, example embodiments are not limited thereto.

The first TMD material may include one or more metal elements (transition metal elements) and one or more non-metal elements (chalcogen elements). Hereinafter, for ease of description, it is assumed that the first TMD material is a semiconductor compound including two elements (elements M and A) and expressed as MA (where the element M is a metal element, and the element A is a non-metal element).

The first source electrode 131 is provided on a side of the first channel layer 111, and the first drain electrode 121 is provided on the other side of the first channel layer 111. The first source electrode 131 and the first drain electrode 121 are in contact with the lateral surfaces of the first channel layer 111, respectively. The first source electrode 131 and the first drain electrode 121 may each include a first topological metal. Here, the first topological metal may include a conductive compound that contains some of elements or at least one element included in the first TMD material of the first channel layer 111.

Topological metals, also referred to as topological conductors, may include at least one metal element, a semimetal element, and/or a non-metal element when the topological metals include a conductive compound. Topological metals exhibit less scattering at interfaces (e.g., surfaces, grain boundaries, or the like) than ordinary metals. Thus, even when the surface-to-volume ratio of topological metals increases, the charge transfer characteristics of the topological metals do not deteriorate. Therefore, voltage drop (IR drop) may be reduced when relatively narrow and/or relatively small electrodes include a topological metal instead of an ordinary metal.

The first topological metal included in the first source electrode 131 and the first drain electrode 121 may include a conductive compound containing some of elements or at least one element included in the first TMD material of the first channel layer 111. For example, when the first TMD material included in the first channel layer 111 includes a semiconductor compound expressed as MA, the first topological metal included in the first source electrode 131 and the first drain electrode 121 may include a conductive compound expressed as ME (where M refers to a metal element, and E refers to a semimetal element or a non-metal element). As described above, the first topological metal included in the first source electrode 131 and the first drain electrode 121 may share the element M with the first TMD material included in the first channel layer 111. For example, when the first TMD material includes MoS₂, the first topological metal may include MoP. For example, when the first TMD material includes WS₂, the first topological metal may include WC. For example, when the first TMD material includes TaS₂, the first topological metal may include TaN. However, these are only examples.

An insulating layer 170 may be formed on an upper surface of the first channel layer 111, and a first via layer 151 for electrical connection may be provided above each of the first source electrode 131 and the first drain electrode 121. The first via layer 151 may include a metal material having relatively high conductivity.

The second transistor TR2 is provided below the first transistor TR1. The second transistor TR2 includes a second channel layer 112, and a second source electrode 132 and a second drain electrode 122 that are provided on both sides of the second channel layer 112, respectively. Here, the second source electrode 132 and the second drain electrode 122 may be in contact with lateral surfaces of the second channel layer 112, respectively.

The second channel layer 112 may include a semiconductor compound of a second conductive type. For example, the second channel layer 112 may include a two-dimensional semiconductor material of the second conductive type. For example, the second channel layer 112 may include a second TMD material. The second TMD material may include an n-type TMD material. Here, the n-type TMD material may include, for example, MoSe₂, MoTe₂, WSe₂, WTe₂, PtSe₂, PtTe₂, or the like However, example embodiments are not limited thereto.

The second TMD material may include one or more metal elements (transition metal elements) and one or more non-metal elements (chalcogen elements). Hereinafter, for ease of description, it is assumed that the second TMD material is a semiconductor compound including two elements (elements M' and D) and expressed as M'D (where the element M' refers to a metal element, and the element D refers to a non-metal element).

The second source electrode 132 is provided on a side of the second channel layer 112, and the second drain electrode 122 is provided on the other side of the second channel layer 112. The second source electrode 132 and the second drain electrode 122 may be in contact with the lateral surfaces of the second channel layer 112, respectively. The second source electrode 132 and the second drain electrode 122 may each include a second topological metal.

The second topological metal included in the second source electrode 132 and the second drain electrode 122 may include a conductive compound that contains some of elements or at least one element included in the second TMD material of the second channel layer 112. For example, when the second TMD material included in the second channel layer 112 includes a semiconductor compound expressed as M'D, the second topological metal included in the second source electrode 132 and the second drain electrode 122 may include a conductive compound expressed as M'E (where M' refers to a metal element, and E refers to a semimetal element or a non-metal element). As described above, the second topological metal included in the second source electrode 132 and the second drain electrode 122 may share the element M' with the second TMD material included in the second channel layer 112. For example, when the second TMD material includes MoTe₂, the second topological metal may include MoP. For example, when the second TMD material includes WTe₂, the second topological metal may include WC. However, these are only examples.

An insulating layer 170 may be formed on a lower surface of the second channel layer 112, and a second via layer 152 for electrical connection may be provided below each of the second source electrode 132 and the second drain electrode 122. The second via layer 152 may include a metal material having relatively high conductivity.

As described above, in the semiconductor device 100 of the example embodiment, the first and second source electrodes 131 and 132 and the first and second drain electrodes 121 and 122 include some of elements or at least one element included in the first and second TMD materials of the first and second channel layers 111 and 112. Thus, the first and second source electrodes 131 and 132 and the first and second drain electrodes 121 and 122 may have seamless surfaces at interfaces with the first and second channel layers 111 and 112, thereby reducing interface resistance. In addition, the first and second source electrodes 131 and 132, the first and second drain electrodes 121 and 122, and the first and second channel layers 111 and 112 may be defined through a single photolithography process and may thus be formed through simple processes. In addition, because the first and second source electrodes 131 and 132 and the first and second drain electrodes 121 and 122 include topological metals, an increase in voltage drop (IR drop) may be reduced or prevented even when the first and second source electrodes 131 and 132 and the first and second drain electrodes 121 and 122 are relatively narrow and/or relatively small. Integration of The semiconductor device 100 may be improved by vertically stacking the first and second transistors TR1 and TR2 in the same area.

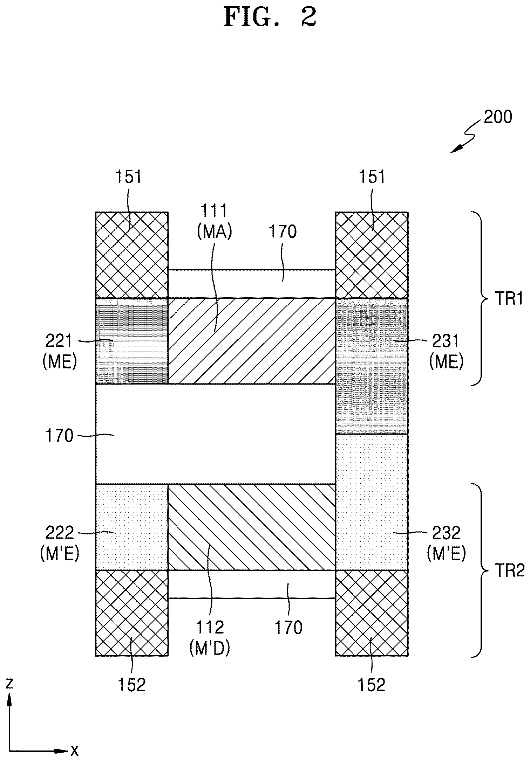

FIG. 2 is a cross-sectional view illustrating a semiconductor device 200 according to an example embodiment. The following description focuses on the differences from the previous example embodiment.

Referring to FIG. 2, a second transistor TR2 is provided below a first transistor TR1. The first transistor TR1 includes a first channel layer 111, and a first source electrode 231 and a first drain electrode 221 that are provided on both sides of the first channel layer 111, respectively. The first channel layer 111 may include a first TMD material (e.g., a p-type TMD material). The first source electrode 231 and the first drain electrode 221 may each include a first topological metal that contains some of elements or at least one element included in the first TMD material. For example, when the first TMD material included in the first channel layer 111 includes a semiconductor compound expressed as MA, the first topological metal included in the first source electrode 231 and the first drain electrode 221 may include a conductive compound expressed as ME.

The second transistor TR2 includes a second channel layer 112, and a second source electrode 232 and a second drain electrode 222 that are provided on both sides of the second channel layer 112, respectively. The second channel layer 112 may include a second TMD material (e.g., an n-type TMD material). The second source electrode 232 and the second drain electrode 222 may each include a second topological metal that contains some of elements or at least one element included in the second TMD material. For example, when the second TMD material included in the second channel layer 112 includes a semiconductor compound expressed as M'D, the second topological metal included in the second source electrode 232 and the second drain electrode 222 may include a conductive compound expressed as M'E.

The first transistor TR1 and the second transistor TR2 are connected to each other in a vertical direction. For example, the first source electrode 231 of the first transistor TR1 is vertically connected to the second source electrode 232 of the second transistor TR2. In this case, an interface may be formed between the first source electrode 231 and the second source electrode 232.

As described above, the first transistor TR1 and the second transistor TR2 are vertically stacked with the first source electrode 231 of the first transistor TR1 and the second source electrode 232 of the second transistor TR2 being vertically connected to each other, implementing a complementary field-effect transistor (CFET). In the description above, the first source electrode 231 of the first transistor TR1 and the second source electrode 232 of the second transistor TR2 are vertically connected to each other. However, example embodiments are not limited thereto. For example, the first drain electrode 221 of the first transistor TR1 and the second drain electrode 222 of the second transistor TR2 may be vertically connected to each other.

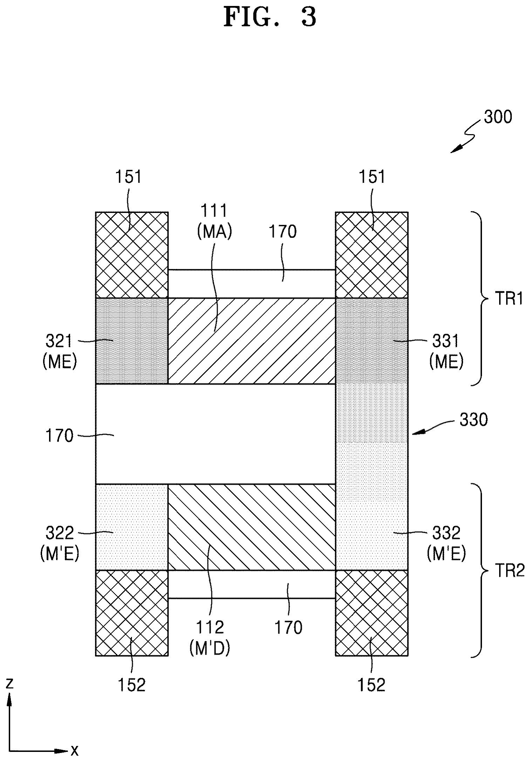

FIG. 3 is a cross-sectional view illustrating a semiconductor device 300 according to an example embodiment. The following description focuses on the differences from the previous example embodiments.

Referring to FIG. 3, a second transistor TR2 is provided below a first transistor TR1. The first transistor TR1 includes a first channel layer 111, and a source electrode 330 and a first drain electrode 321 that are provided on both sides of the first channel layer 111, respectively. The second transistor TR2 includes a second channel layer 112, the source electrode 330, and a second drain electrode 322. The source electrode 330 and the second drain electrode 322 are provided on both sides of the second channel layer 112, respectively. Here, the source electrode 330 is provided as one body and configured to vertically connect the first transistor TR1 and the second transistor TR2 to each other.

The first channel layer 111 may include a first TMD material (e.g., a p-type TMD material). The first drain electrode 321 may include a first topological metal that contains some of elements or at least one element included in the first TMD material. For example, when the first TMD material included in the first channel layer 111 includes a semiconductor compound expressed as MA, the first topological metal included in the first drain electrode 321 may include a conductive compound expressed as ME. The second channel layer 112 may include a second TMD material (e.g., an n-type TMD material). The second drain electrode 322 may include a second topological metal that contains some of elements or at least one element included in the second TMD material. For example, when the second TMD material included in the second channel layer 112 includes a semiconductor compound expressed as M'D, the second topological metal included in the second drain electrode 322 may include a conductive compound expressed as M'E.

The source electrode 330 may be formed as one body and may include an alloy having a chemical composition gradually changing in a direction from an upper portion 331 of the source electrode 330 toward a lower portion 332 of the source electrode 330. For example, the upper portion 331 of the source electrode 330, which is in contact with the first channel layer 111, may include the same material as the first drain electrode 321. That is, the upper portion 331 of the source electrode 330 may include the first topological metal. The first topological metal may include a conductive compound expressed as ME. The lower portion 332 of the source electrode 330, which is in contact with the second channel layer 112, may include the same material as the second drain electrode 322. That is, the lower portion 332 of the source electrode 330 may include the second topological metal. The second topological metal may include a conductive compound expressed as M'E. In addition, the chemical composition of the source electrode 330 may gradually change from the first topological metal (expressed as ME) to the second topological metal (expressed as M'E) in a direction from the upper portion 331 of the source electrode 330 toward the lower portion 332 of the source electrode 330. A first via layer 151 is provided above each of the source electrode 330 and the first drain electrode 321, and a second via layer 152 is provided below each of the source electrode 330 and the second drain electrode 322.

In the current example embodiment, the first transistor TR1 and the second transistor TR2 are vertically connected to each other through a common electrode, that is, the source electrode 330, thereby implementing a CFET. In this case, source electrodes (the source electrode 330) of the first and second transistors TR1 and TR2 may be simultaneously formed, and thus, the number of process operations may be reduced. In addition, because there is no interface in the source electrode 330 of the first transistor TR1 and the second transistor TR2, interface resistance may be reduced.

The description above is of an example in which the first transistor TR1 and the second transistor TR2 are vertically connected to each other through a common source electrode, that is, the source electrode 330. However, example embodiments are not limited thereto. For example, the first transistor TR1 and the second transistor TR2 may instead be vertically connected to each other through a common drain electrode (not shown).

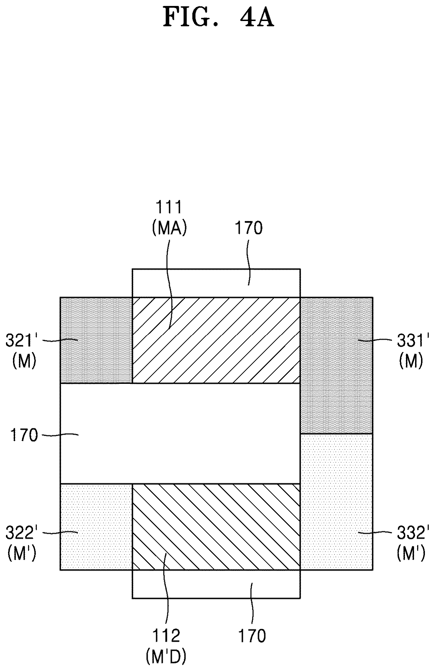

FIGS. 4A to 4C are views illustrating a method of manufacturing the semiconductor device 300 shown in FIG. 3.

Referring to FIG. 4A, a first source electrode layer 331' and a first drain electrode layer 321' are formed on both sides of a first channel layer 111, respectively, and a second source electrode layer 332' and a second drain electrode layer 322' are formed on both sides of a second channel layer 112, respectively. Here, the first source electrode layer 331' and the second source electrode layer 332' are formed to be in contact with each other. The first channel layer 111 includes a semiconductor compound expressed as MA, and the first source electrode layer 331' and the first drain electrode layer 321' include a metal material expressed as M. The second channel layer 112 includes a semiconductor compound expressed as M'D, and the second source electrode layer 332' and the second drain electrode layer 322' include a metal material expressed as M'.

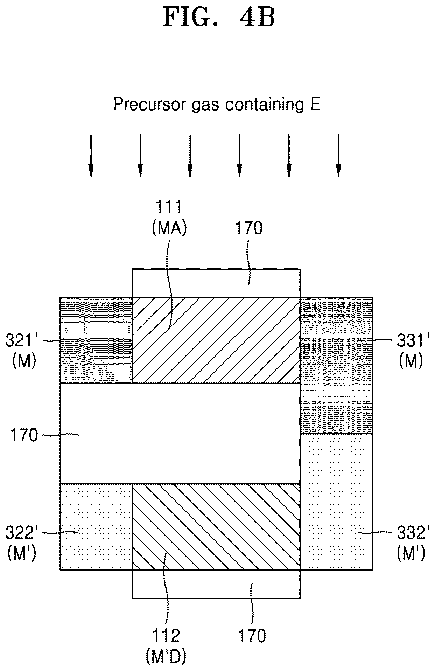

Referring to FIG. 4B, a precursor gas containing an element E is injected into a structure shown in FIG. 4A. As a result, the element E is injected into the first source electrode layer 331', the first drain electrode layer 321', the second source electrode layer 332', and the second drain electrode layer 322', and element diffusion occurs through an interface between the first source electrode layer 331' and the second source electrode layer 332'.

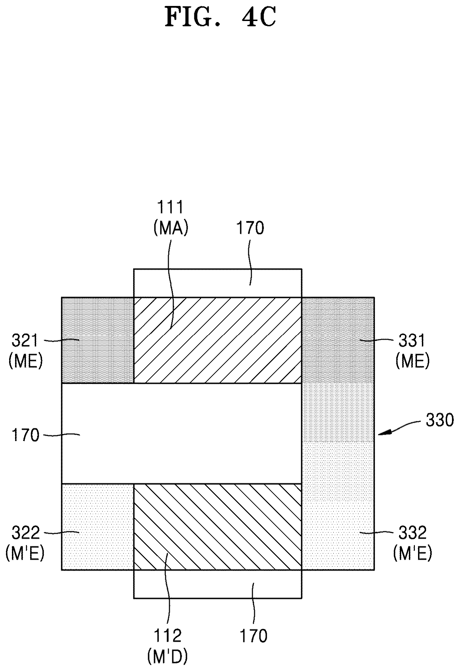

Referring to FIG. 4C, the first drain electrode layer 321' is transformed into a first drain electrode 321 including a first topological metal expressed as ME owing to the injection of the element E, and the second drain electrode layer 322' is transformed into a second drain electrode 322 including a second topological metal expressed as M'E owing to the injection of the element E. In addition, as the first source electrode layer 331' and the second source electrode layer 332' are integrally formed, a source electrode 330 is formed, which includes an alloy having a chemical composition changing in a direction from an upper portion 331 of the source electrode 330 toward a lower portion 332 of the source electrode 330 owing to the injection of the element E. The upper portion 331 of the source electrode 330, which is in contact with the first channel layer 111, includes a first topological metal expressed as ME, and the lower portion 332 of the source electrode 330, which is in contact with the second channel layer 112, includes a second topological metal expressed as M'E.

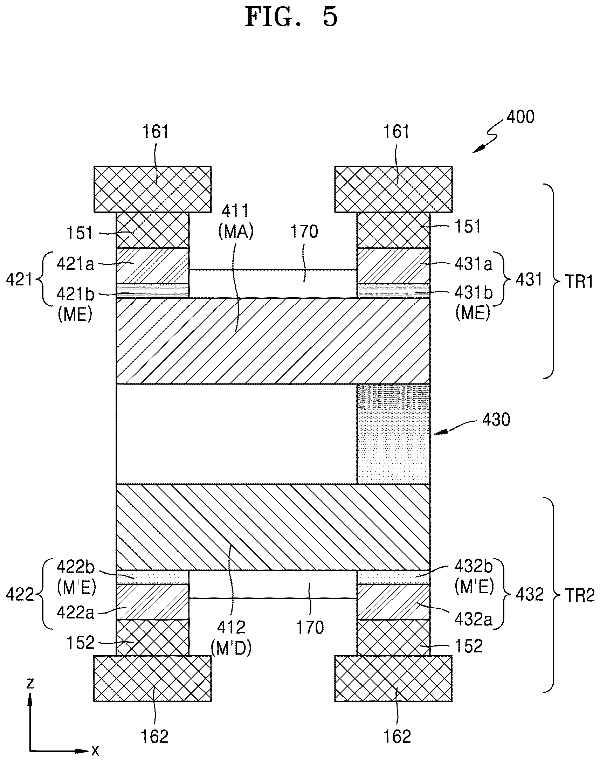

FIG. 5 is a cross-sectional view illustrating a semiconductor device 400 according to an example embodiment. The following description focuses on the differences from the previous example embodiments.

Referring to FIG. 5, a second transistor TR2 is provided below a first transistor TR1. The first transistor TR1 includes a first channel layer 411, and a first source electrode 431 and a first drain electrode 421 that are provided on upper surface portions of both sides of the first channel layer 411, respectively. A first via layer 151 is provided above each of the first source electrode 431 and the first drain electrode 421, and a first interconnect layer 161 is provided above the first via layer 151.

The first channel layer 411 may include a first TMD material (e.g., a p-type TMD material). The first source electrode 431 is provided on the upper surface of a side of the first channel layer 411. The first source electrode 431 includes a first interface layer 431b that is in contact with the upper surface of the side of the first channel layer 411, and a first metal layer 431a that is provided on the first interface layer 431b. Here, the first interface layer 431b may include a first topological metal containing some of elements or at least one element included in the first TMD material. The first metal layer 431a may include a relatively highly conductive ordinary metal (e.g., Au, Al, Cu, or the like). The first drain electrode 421 is provided on the upper surface of the other side of the first channel layer 411. The first drain electrode 421 includes a first interface layer 421b that is in contact with the upper surface of the other side of the first channel layer 411, and a first metal layer 421a that is provided on the first interface layer 421b. Here, the first interface layer 421b may include the first topological metal containing some of elements or at least one element included in the first TMD material. The first metal layer 421a may include a relatively highly conductive ordinary metal (e.g., Au, Al, Cu, or the like).

The second transistor TR2 includes a second channel layer 412, and a second source electrode 432 and a second drain electrode 422 that are provided on lower surfaces of both sides of the second channel layer 412, respectively. A second via layer 152 is provided below each of the second source electrode 432 and the second drain electrode 422, and a second interconnect layer 162 is provided below the second via layer 152.

The second channel layer 412 may include a second TMD material (e.g., an n-type TMD material). The second source electrode 432 is provided on the lower surface of a side of the second channel layer 412. The second source electrode 432 includes a second interface layer 432b that is in contact with the lower surface of the side of the second channel layer 412, and a second metal layer 432a that is provided on the second interface layer 432b. Here, the second interface layer 432b may include a second topological metal containing some of elements or at least one element included in the second TMD material. The second metal layer 432a may include a relatively highly conductive ordinary metal (e.g., Au, Al, Cu, or the like). The second drain electrode 422 is provided on the lower surface of the other side of the second channel layer 412. The second drain electrode 422 includes a second interface layer 422b that is in contact with the lower surface of the other side of the second channel layer 412, and a second metal layer 422a that is provided on the second interface layer 422b. Here, the second interface layer 422b may include the second topological metal containing some of elements or at least one element included in the second TMD material. The second metal layer 422a may include a relatively highly conductive ordinary metal (e.g., Au, Al, Cu, or the like).

The first transistor TR1 and the second transistor TR2 are vertically connected to each other through a common source electrode 430. Here, an upper portion of the common source electrode 430, which is in contact with a lower surface of the first channel layer 411, may include the first topological metal included in the first interface layer 431b of the first source electrode 431, and a lower portion of the common source electrode 430, which is in contact with an upper surface of the second channel layer 412, may include the second topological metal included in the second interface layer 432b of the second source electrode 432. Furthermore, the chemical composition of the common source electrode 430 may gradually change from the first topological metal to the second topological metal in a direction from the upper portion of the common source electrode 430 toward the lower portion of the common source electrode 430.

In the current example embodiment, the first source electrode 431, the first drain electrode 421, the second source electrode 432, and the second drain electrode 422 include the first and second interface layers 431b, 421b, 432b, and 422b that are in contact with corresponding ones of the first and second channel layers 411 and 412, respectively, and the first and second interface layers 431b, 421b, 432b, and 422b include the first topological metal or the second topological metal that contain some of elements or at least one element included in the first channel layer 411 or the second channel layer 412. Therefore, the first source electrode 431, the first drain electrode 421, the second source electrode 432, and the second drain electrode 422 may have low contact resistance with corresponding ones of the first and second channel layers 411 and 412, respectively.

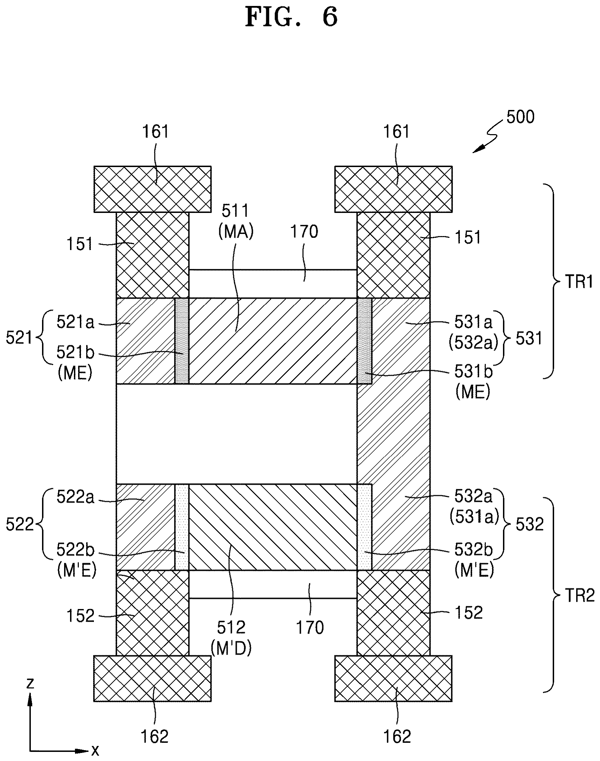

FIG. 6 is a cross-sectional view illustrating a semiconductor device 500 according to an example embodiment. The following description focuses on the differences from the previously described example embodiments.

Referring to FIG. 6, a second transistor TR2 is provided below a first transistor TR1. The first transistor TR1 includes a first channel layer 511, and a first source electrode 531 and a first drain electrode 521 that are provided on both sides of the first channel layer 511, respectively. The first channel layer 511 may include a first TMD material e.g., a p-type TMD material). The first source electrode 531 is provided on a lateral surface of the first channel layer 511. The first source electrode 531 includes a first interface layer 531b that is in contact with the lateral surface of the first channel layer 511, and a metal layer 531a that is provided on the first interface layer 531b. The metal layer 531a may be provided as one body and may vertically connect the first transistor TR1 and the second transistor TR2 to each other. The first interface layer 531b may include a first topological metal containing some of elements or at least one element included in the first TMD material. The metal layer 531a may include a relatively highly conductive ordinary metal (e.g., Au, Al, Cu, or the like).

The first drain electrode 521 is provided on another lateral surface of the first channel layer 511. The first drain electrode 521 includes a first interface layer 521b that is in contact with the another lateral surface of the first channel layer 511, and a first metal layer 521a that is provided on the first interface layer 521b. Here, the first interface layer 521b may include the first topological metal containing some of elements or at least one element included in the first TMD material. The first metal layer 521a may include a relatively highly conductive ordinary metal (e.g., Au, Al, Cu, or the like).

The second transistor TR2 includes a second channel layer 512, and a second source electrode 532 and a second drain electrode 522 that are provided on both sides of the second channel layer 512, respectively. The second channel layer 512 may include a second TMD material (e.g., an n-type TMD material). The second source electrode 532 is provided on a lateral surface of the second channel layer 512. The second source electrode 532 includes a second interface layer 532b that is in contact with the lateral surface of the second channel layer 512, and a metal layer 532a that is provided on the second interface layer 532b. As described above, the metal layer 532a may be provided as one body and may vertically connect the first transistor TR1 and the second transistor TR2 to each other. The second interface layer 532b may include a second topological metal containing some of elements or at least one element included in the second TMD material.

The second drain electrode 522 is provided on another lateral surface of the second channel layer 512. The second drain electrode 522 includes a second interface layer 522b that is in contact with the another lateral surface of the second channel layer 512, and a second metal layer 522a that is provided on the second interface layer 522b. Here, the second interface layer 522b may include the second topological metal containing some of elements or at least one element included in the second TMD material. The second metal layer 522a may include a relatively highly conductive ordinary metal (e.g., Au, Al, Cu, or the like).

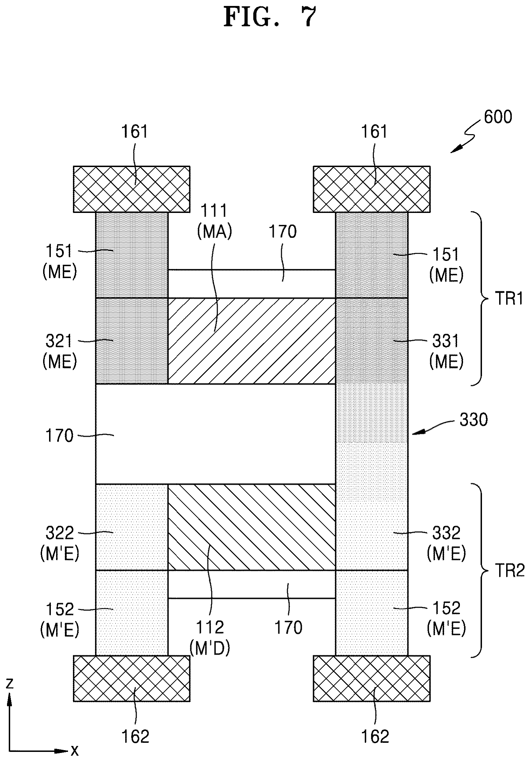

FIG. 7 is a cross-sectional view illustrating a semiconductor device 600 according to an example embodiment. The semiconductor device 600 shown in FIG. 7 is the same as the semiconductor device 300 shown in FIG. 3, except for first and second via layers 151 and 152. The following description focuses on differences from the semiconductor device 300 shown in FIG. 3.

Referring to FIG. 7, a second transistor TR2 is provided below a first transistor TR1. The first transistor TR1 includes a first channel layer 111, and a source electrode 330 and a first drain electrode 321 that are provided on both sides of the first channel layer 111, respectively. The second transistor TR2 includes a second channel layer 112, the source electrode 330, and a second drain electrode 322. The source electrode 330 and the second drain electrode 322 are provided on both sides of the second channel layer 112, respectively. Here, the source electrode 330 is provided as one body and configured to vertically connect the first transistor TR1 and the second transistor TR2 to each other.

The first channel layer 111 may include a first TMD material (e.g., a p-type TMD material). The first drain electrode 321 may include a first topological metal containing some of elements or at least one element included in the first TMD material. The second channel layer 112 may include a second TMD material (e.g., an n-type TMD material). The second drain electrode 322 may include a second topological metal containing some of elements or at least one element included in the second TMD material.

The source electrode 330 may be formed as one body and may include an alloy having a chemical composition gradually changing in a direction from an upper portion 331 of the source electrode 330 to a lower portion 332 of the source electrode 330. For example, the upper portion 331 of the source electrode 330, which is in contact with the first channel layer 111, may include the same material as the first drain electrode 321. That is, the upper portion 331 of the source electrode 330 may include the first topological metal. In addition, the lower portion 332 of the source electrode 330, which is in contact with the second channel layer 112, may include the same material as the second drain electrode 322. That is, the lower portion 332 of the source electrode 330 may include the second topological metal. In addition, the chemical composition of the source electrode 330 may gradually change from the first topological metal (expressed as ME) to the second topological metal (expressed as M'E) in a direction from the upper portion 331 of the source electrode 330 toward the lower portion 332 of the source electrode 330.

The first via layer 151 is provided above each of the source electrode 330 and the first drain electrode 321, and the second via layer 152 is provided below each of the source electrode 330 and the second drain electrode 322. In addition, a first interconnect layer 161 is provided above the first via layer 151, and a second interconnect layer 162 is provided below the second via layer 152. The first and second interconnect layers 161 and 162 may include a relatively highly conductive ordinary metal (e.g., Au, Al, Cu, or the like).

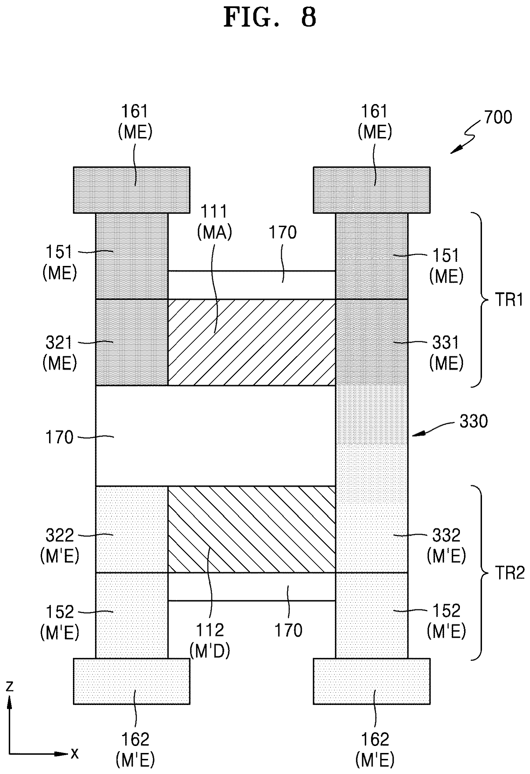

In the current example embodiment, the first via layer 151 may include the same material as the upper portion 331 of the source electrode 330 and the first drain electrode 321. That is, the first via layer 151 may include the first topological metal. In addition, the second via layer 152 may include the same material as the lower portion 332 of the source electrode 330 and the second drain electrode 322. That is, the second via layer 152 may include the second topological metal. Because the first and second via layers 151 and 152 include topological metals as described above, interface resistance between the first and second via layers 151 and 152 and other layers may be reduced. Furthermore, as in a semiconductor device 700 shown in FIG. 8, the first via layer 151 and the first interconnect layer 161 may include the first topological metal, and the second via layer 152 and the second interconnect layer 162 may include the second topological metal.

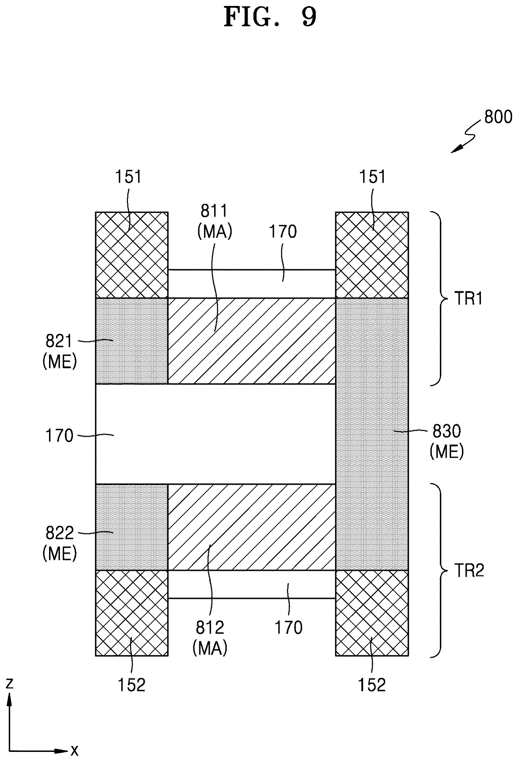

FIG. 9 is a cross-sectional view illustrating a semiconductor device 800 according to an example embodiment. The following description focuses on the differences from the previous example embodiments.

Referring to FIG. 9, the semiconductor device 800 includes a first transistor TR1 and a second transistor TR2 that are stacked apart from each other in a vertical direction (z-axis direction). An insulating layer 170 may be provided between the first transistor TR1 and the second transistor TR2. The first and second transistors TR1 and TR2 may each be a PMOS transistor.

The first transistor TR1 includes a first channel layer 811, and a source electrode 830 and a first drain electrode 821 that are provided on both sides of the first channel layer 811, respectively. The second transistor TR2 includes a second channel layer 812, the source electrode 830, and a second drain electrode 822. The source electrode 830 and the second drain electrode 822 are provided on both sides of the second channel layer 812, respectively. Here, the source electrode 830 is provided as one body and configured to vertically connect the first transistor TR1 and the second transistor TR2 to each other.

The first channel layer 811 may include a first TMD material. Here, the first TMD material may be a p-type TMD material. The first drain electrode 821 may include a first topological metal containing some of elements or at least one element included in the first TMD material. For example, when the first TMD material included in the first channel layer 811 includes a semiconductor compound expressed as MA, the first topological metal included in the first drain electrode 821 may include a conductive compound expressed as ME.

The second channel layer 812 may include a second TMD material. Here, the second TMD material may be a p-type TMD material. The second TMD material may be the same as the first TMD material. The second drain electrode 822 may include a second topological metal containing some of elements or at least one element included in the second TMD material. Here, the second topological metal may be the same as the first topological metal. For example, when the second TMD material included in the second channel layer 812 includes a semiconductor compound expressed as MA, the second topological metal included in the second drain electrode 822 may include a conductive compound expressed as ME.

The source electrode 830 is formed as one body and may include the same conductive compound (topological metal) as the first drain electrode 821 and the second drain electrode 822. For example, when the first drain electrode 821 and the second drain electrode 822 include a conductive compound expressed as ME, the source electrode 830 may also include a conductive compound expressed as ME.

The description above is of an example in which the second TMD material is the same as the first TMD material, and the second topological metal is the same as the first topological metal. However, the second TMD material may be different from the first TMD material, and the second topological metal may be different from the first topological metal.

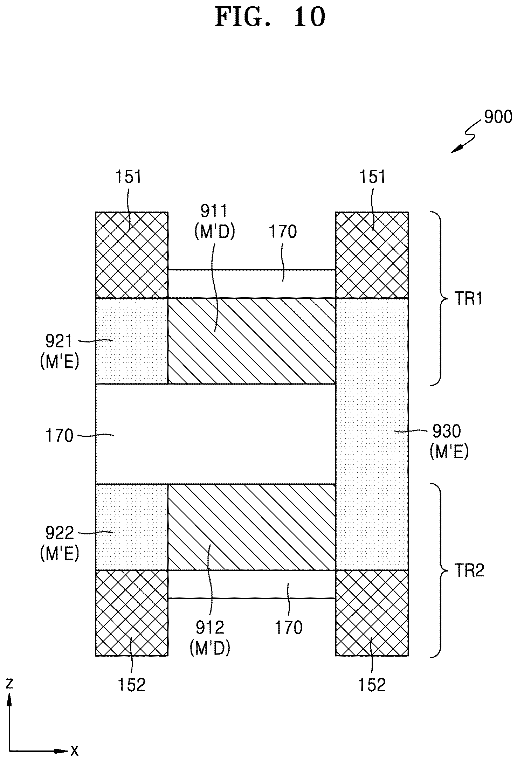

FIG. 10 is a cross-sectional view illustrating a semiconductor device 900 according to an example embodiment. The following description focuses on the differences from the previous example embodiments.

Referring to FIG. 10, the semiconductor device 900 includes a first transistor TR1 and a second transistor TR2 that are stacked apart from each other in a vertical direction (z-axis direction). The first and second transistors TR1 and TR2 may each be an NMOS transistor.

The first transistor TR1 includes a first channel layer 911, and a source electrode 930 and a first drain electrode 921 that are provided on both sides of the first channel layer 911, respectively. The second transistor TR2 includes a second channel layer 912, the source electrode 930, and a second drain electrode 922. The source electrode 930 and the second drain electrode 922 are provided on both sides of the second channel layer 912, respectively. Here, the source electrode 930 is provided as one body and configured to vertically connect the first transistor TR1 and the second transistor TR2 to each other.

The first channel layer 911 may include a first TMD material. Here, the first TMD material may be an n-type TMD material. The first drain electrode 921 may include a first topological metal containing some of elements or at least one element included in the first TMD material. For example, when the first TMD material included in the first channel layer 911 includes a semiconductor compound expressed as M'D, the first topological metal included in the first drain electrode 921 may include a conductive compound expressed as M'E.

The second channel layer 912 may include a second TMD material. Here, the second TMD material may be an n-type TMD material. The second TMD material may be the same as the first TMD material. The second drain electrode 922 may include a second topological metal containing some of elements or at least one element included in the second TMD material. Here, the second topological metal may be the same as the first topological metal. For example, when the second TMD material included in the second channel layer 912 includes a semiconductor compound expressed as M'D, the second topological metal included in the second drain electrode 922 may include a conductive compound expressed as M'E.

The source electrode 930 is formed as one body and may include the same conductive compound (topological metal) as the first drain electrode 921 and the second drain electrode 922. For example, when the first drain electrode 921 and the second drain electrode 922 include a conductive compound expressed as M'E, the source electrode 930 may also include a conductive compound expressed as M'E.

The description above is of an example in which the second TMD material is the same as the first TMD material, and the second topological metal is the same as the first topological metal. However, the second TMD material may be different from the first TMD material, and the second topological metal may be different from the first topological metal.

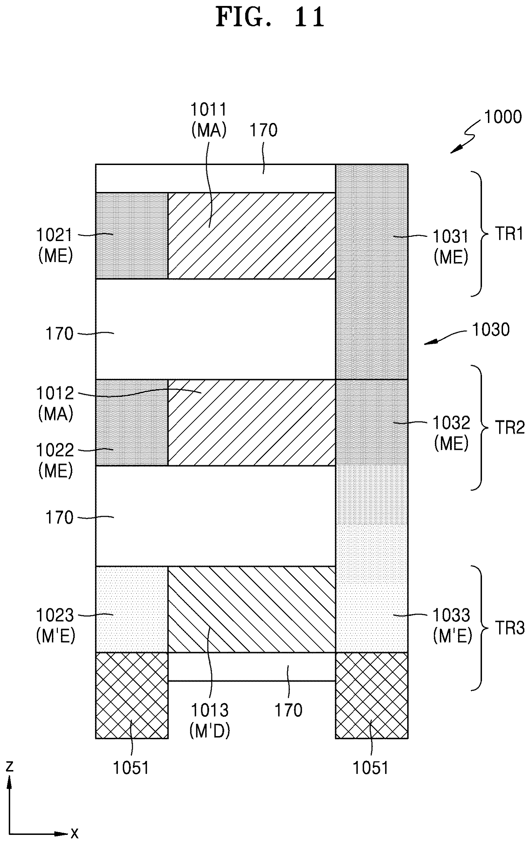

FIG. 11 is a cross-sectional view illustrating a semiconductor device 1000 according to an example embodiment. The following description focuses on the differences from the previous example embodiments.

Referring to FIG. 11, the semiconductor device 1000 includes first, second, and third transistors TR1, TR2, and TR3 that are stacked apart from each other in a vertical direction (z-axis direction). An insulating layer 170 may be provided between the first transistor TR1 and the second transistor TR2, and an insulating layer 170 may be provided between the second transistor TR2 and the third transistor TR3. The first and second transistors TR1 and TR2 may be PMOS transistors, and the third transistor TR3 may be an NMOS transistor.

The first transistor TR1 includes a first channel layer 1011, and a source electrode 1030 and a first drain electrode 1021 that are provided on both sides of the first channel layer 1011, respectively. The second transistor TR2 includes a second channel layer 1012, the source electrode 1030, and a second drain electrode 1022. The source electrode 1030 and the second drain electrode 1022 are provided on both sides of the second channel layer 1012, respectively. The third transistor TR3 includes a third channel layer 1013, the source electrode 1030, and a third drain electrode 1023. The source electrode 1030 and the third drain electrode 1023 are provided on both sides of the third channel layer 1013, respectively. Here, the source electrode 1030 is provided as one body and configured to vertically connect the first, second, and third transistors TR1, TR2, and TR3 to each other

The first channel layer 1011 may include a first TMD material. Here, the first TMD material may be a p-type TMD material. The first drain electrode 1021 may include a first topological metal containing some of elements or at least one element included in the first TMD material. For example, when the first TMD material included in the first channel layer 1011 includes a semiconductor compound expressed as MA, the first topological metal included in the first drain electrode 1021 may include a conductive compound expressed as ME.

The second channel layer 1012 may include a second TMD material. Here, the second TMD material may be a p-type TMD material. The second TMD material may be the same as the first TMD material. The second drain electrode 1022 may include a second topological metal containing some of elements or at least one element included in the second TMD material. Here, the second topological metal may be the same as the first topological metal. For example, when the second TMD material included in the second channel layer 1012 includes a semiconductor compound expressed as MA, the second topological metal included in the second drain electrode 1022 may include a conductive compound expressed as ME.

The third channel layer 1013 may include a third TMD material. Here, the third TMD material may be an n-type TMD material. The third drain electrode 1023 may include a third topological metal containing some of elements or at least one element included in the third TMD material. For example, when the third TMD material included in the third channel layer 1013 includes a semiconductor compound expressed as M'D, the third topological metal included in the third drain electrode 1023 may include a conductive compound expressed as M'E.

The source electrode 1030, which is formed as one body, may include an upper portion 1031 that is in contact with the first channel layer 1011, a middle portion 1032 that is in contact with the second channel layer 1012, and a lower portion 1033 that is in contact with the third channel layer 1013. Here, the upper portion 1031 of the source electrode 1030 may include the same conductive compound (the first topological metal) as the first drain electrode 1021, the middle portion 1032 of the source electrode 1030 may include the same conductive compound (the second topological metal) as the second drain electrode 1022, and the lower portion 1033 of the source electrode 1030 may include the same conductive compound (the third topological metal) as the third drain electrode 1023. For example, the upper portion 1031 of the source electrode 1030 may include a conductive compound expressed as ME, the middle portion 1032 of the source electrode 1030 may include a conductive compound expressed as ME, and the lower portion 1033 of the source electrode 1030 may include a conductive compound expressed as M'E. In addition, the chemical composition of the source electrode 1030 may gradually change from the second topological metal (expressed as ME) to the third topological metal (expressed as M'E) in a direction from the middle portion 1032 toward the lower portion 1033. A via layer 1051 is provided below each of the third drain electrode 1023 and the source electrode 1030.

The description above is of an example in which the second TMD material is the same as the first TMD material, and the second topological metal is the same as the first topological metal. However, the second TMD material may be different from the first TMD material, and the second topological metal may be different from the first topological metal.

The description above is of an example in which the first, second, and third transistors TR1, TR2, and TR3 are a PMOS transistor, a PMOS transistor, and an NMOS transistor, respectively. However, example embodiments are not limited thereto. For example, each of the first, second, and third transistors TR1, TR2, and TR3 may independently be a PMOS transistor or an NMOS transistor. Furthermore, the description above is of an example in which the semiconductor device 1000 includes three vertically stacked transistors, that is, the first, second, and third transistors TR1, TR2, and TR3. However, example embodiments are not limited thereto, and the semiconductor device 1000 may include four or more vertically stacked transistors.

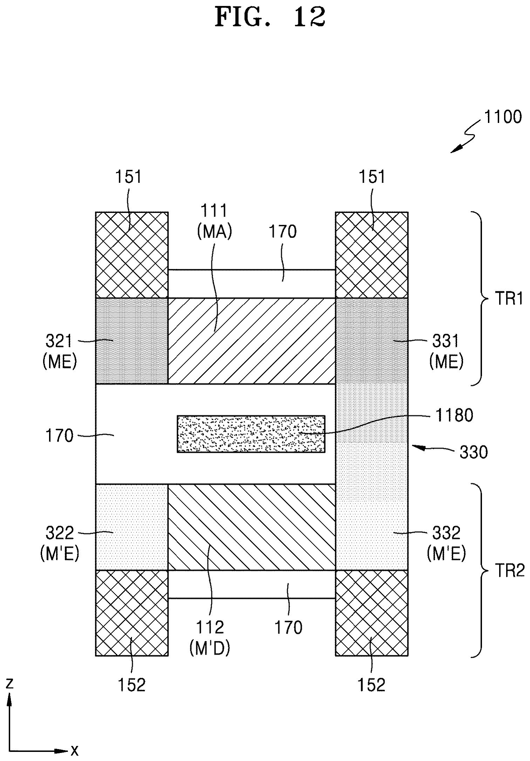

FIG. 12 is a cross-sectional view illustrating a semiconductor device 1100 according to an example embodiment. The semiconductor device 1100 shown in FIG. 12 is the same as the semiconductor device 300 shown in FIG. 3, except that a gate electrode 1180 is provided within an insulating layer 170 between a first transistor TR1 and a second transistor TR2. The semiconductor device 1100 shown in FIG. 12 may include an inverter device. The following description focuses on the differences from the previous example embodiments.

Referring to FIG. 12, the second transistor TR2 is provided below the first transistor TR1. The first transistor TR1 includes a first channel layer 111, and a source electrode 330 and a first drain electrode 321 that are provided on both sides of the first channel layer 111, respectively. The second transistor TR2 includes a second channel layer 112, the source electrode 330, and a second drain electrode 322. The source electrode 330 and the second drain electrode 322 are provided on both sides of the second channel layer 112, respectively. Here, the source electrode 330 is provided as one body and configured to vertically connect the first transistor TR1 and the second transistor TR2 to each other.

The first channel layer 111 may include a first TMD material (e.g., a p-type TMD material). The first drain electrode 321 may include a first topological metal containing some of elements or at least one element included in the first TMD material. The second channel layer 112 may include a second TMD material (e.g., an n-type TMD material). The second drain electrode 322 may include a second topological metal containing some of elements or at least one element included in the second TMD material.

The source electrode 330 may be provided as one body and may include an alloy having a chemical composition gradually changing in a direction from an upper portion 331 of the source electrode 330 toward a lower portion 332 of the source electrode 330. For example, the upper portion 331 of the source electrode 330, which is in contact with the first channel layer 111, may include the same material as the first drain electrode 321. That is, the upper portion 331 of the source electrode 330 may include the first topological metal. In addition, the lower portion 332 of the source electrode 330, which is in contact with the second channel layer 112, may include the same material as the second drain electrode 322. That is, the lower portion 332 of the source electrode 330 may include the second topological metal. Furthermore, the chemical composition of the source electrode 330 may gradually change from the first topological metal to the second topological metal in a direction from the upper portion 331 of the source electrode 330 toward the lower portion 332 of the source electrode 330.

An insulating layer 170 is provided between the first channel layer 111 and the second channel layer 112, and the gate electrode 1180 is provided inside the insulating layer 170. Here, the gate electrode 1180 may be provided between the first channel layer 111 and the second channel layer 112 and shared by the first transistor TR1 and the second transistor TR2.

The gate electrode 1180 may include a conductive material. For example, the gate electrode 1180 may include metal, metal nitride, metal oxide, polysilicon, or the like. For example, the gate electrode 1180 may include at least one selected from W, TiN, TaN, WN, NbN, Mo, Ru, Ir, RuO, IrO, and relatively highly doped polysilicon. However, example embodiments are not limited thereto.

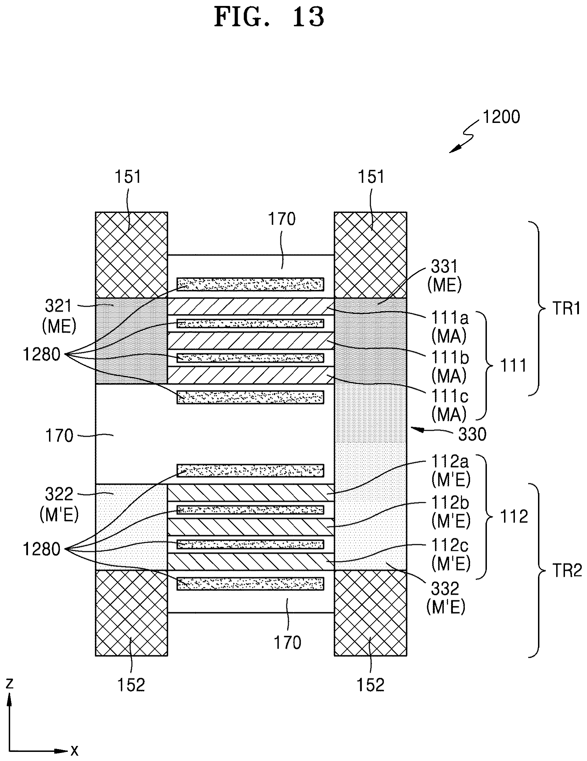

FIG. 13 is a cross-sectional view illustrating a semiconductor device 1200 according to an example embodiment. The following description focuses on the differences from the previous example embodiments.

Referring to FIG. 13, a first transistor TR1 includes a first channel layer 111, and a source electrode 330 and a first drain electrode 321 that are provided on both sides of the first channel layer 111, respectively. The second transistor TR2 includes a second channel layer 112, the source electrode 330, and a second drain electrode 322. The source electrode 330 and the second drain electrode 332 are provided on both sides of the second channel layer 112, respectively. Here, the source electrode 330 is provided as one body and configured to vertically connect the first transistor TR1 and the second transistor TR2 to each other. An insulating layer 170 is provided between the first channel layer 111 and the second channel layer 112.

The first channel layer 111 may include a plurality of first sub-channel layers 111a, 111b, and 111c that are arranged in parallel with each other and apart from each other. An insulating layer 170 is provided between the first sub-channel layers 111a, 111b, and 111c. Each of the first sub-channel layers 111a, 111b, and 111c may include a first TMD material, and the first drain electrode 321 may include a first topological metal containing some of elements or at least one element included in the first TMD material. The second channel layer 112 may include a plurality of second sub-channel layers 112a, 112b, and 112c that are arranged in parallel with each other and apart from each other. An insulating layer 170 is provided between the second sub-channel layers 112a, 112b, and 112c. Each of the second sub-channel layers 112a, 112b, and 112c may include a second TMD material, and the second drain electrode 322 may include a second topological metal containing some of elements or at least one element included in the second TMD material.

The source electrode 330 is formed as one body and may include an alloy having a chemical composition gradually changing in a direction from an upper portion 331 of the source electrode 330 toward a lower portion 332 of the source electrode 330. For example, the upper portion 331 of the source electrode 330, which is in contact with the first channel layer 111, may include the same material as the first drain electrode 321. That is, the upper portion 331 of the source electrode 330 may include the first topological metal. In addition, the lower portion 332 of the source electrode 330, which is in contact with the second channel layer 112, may include the same material as the second drain electrode 322. That is, the lower portion 332 of the source electrode 330 may include the second topological metal. Furthermore, the chemical composition of the source electrode 330 may gradually change from the first topological metal to the second topological metal in a direction from the upper portion 331 toward the lower portion 332.

A gate electrode 1280 is provided inside the insulating layers 170. The gate electrode 1280 surrounds the first sub-channel layers 111a, 111b, and 111c, and the second sub-channel layers 112a, 112b, and 112c. For example, the gate electrode 1280 surround all four sides of each of the first sub-channel layers 111a, 111b, and 111c, and four sides of each of the second sub-channel layers 112a, 112b, and 112c. The gate electrode 1280 may be shared by the first transistor TR1 and the second transistor TR2.

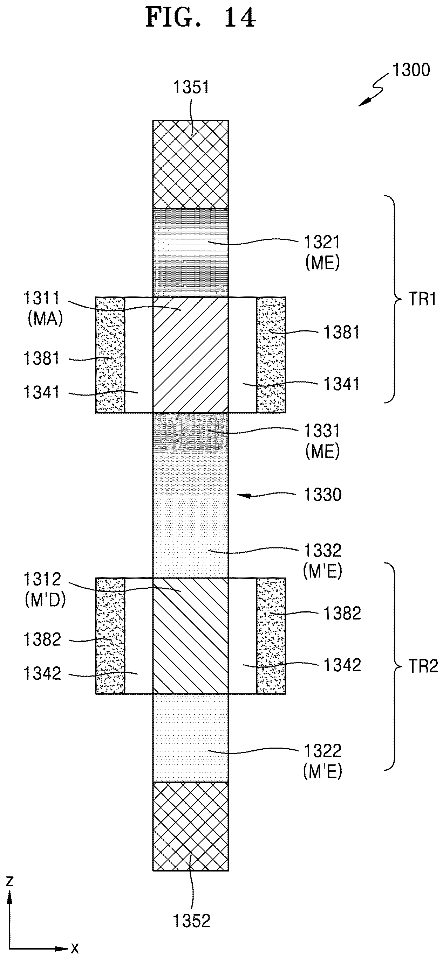

FIG. 14 is a cross-sectional view illustrating a semiconductor device 1300 according to an example embodiment. The following description focuses on the differences from the previous example embodiments.

Referring to FIG. 14, the semiconductor device 1300 includes a first transistor TR1 and a second transistor TR2 that are stacked in a vertical direction (z-axis direction). The first transistor TR1 includes a first channel layer 1311, and a source electrode 1330 and a first drain electrode 1321 that are provided below and above the first channel layer 1311, respectively. A first insulating layer 1341 surrounds the first channel layer 1311, and a first gate electrode 1381 surrounds the first insulating layer 1341. A first via layer 1351 may be provided above the first drain electrode 1321.

The second transistor TR2 is provided below the first transistor TR1. The second transistor TR2 includes a second channel layer 1312, the source electrode 1330, and a second drain electrode 1322. The source electrode 1330 and the second drain electrode 1322 are provided above and below the second channel layer 1312, respectively. A second insulating layer 1342 surrounds the second channel layer 1312, and a second gate electrode 1382 surrounds the second insulating layer 1342. A second via layer 1352 may be provided below the second drain electrode 1322.

The first channel layer 1311 may include a first TMD material (for example, a p-type TMD material). The first drain electrode 1321 may include a first topological metal containing some of elements or at least one element included in the first TMD material. For example, when the first TMD material included in the first channel layer 1311 includes a semiconductor compound expressed as MA, the first topological metal included in the first drain electrode 1321 may include a conductive compound expressed as ME.

The second channel layer 1312 may include a second TMD material (for example, an n-type TMD material). The second drain electrode 1322 may include a second topological metal containing some of elements or at least one element included in the second TMD material. For example, when the second TMD material included in the second channel layer 1312 includes a semiconductor compound expressed as M'D, the second topological metal included in the second drain electrode 1322 may include a conductive compound expressed as M'E.

The source electrode 1330 is provided as one body and configured to vertically connect the first transistor TR1 and the second transistor TR2 to each other. The source electrode 1330 may include an alloy having a chemical composition gradually changing in a direction from an upper portion 1331 of the source electrode 1330 toward a lower portion 1332 of the source electrode 1330. For example, the upper portion 1331 of the source electrode 1330, which is in contact with a lower surface of the first channel layer 1311, may include the same material as the first drain electrode 1321. That is, the upper portion 1331 of the source electrode 1330 may include the first topological metal. The first topological metal may include a conductive compound expressed as ME. In addition, the lower portion 1332 of the source electrode 1330, which is in contact with the upper surface of the second channel layer 1312, may include the same material as the second drain electrode 1322. That is, the lower portion 1332 of the source electrode 1330 may include the second topological metal. The second topological metal may include a conductive compound expressed as M'E. Furthermore, the chemical composition of the source electrode 1330 may gradually change from the first topological metal (expressed as ME) to the second topological metal (expressed as M'E) in a direction from the upper portion 1331 of the source electrode 1330 toward the lower portion 1332 of the source electrode 1330.

As described above, according to one or more of the example embodiments described above, source/drain electrodes include some of elements or at least one element included in a TMD material of a channel layer, and thus, seamless interfaces may be formed between the channel layer and the source/drain electrodes. Therefore, the interface resistance between the channel layer and the source/drain electrodes may be reduced. In addition, the source/drain electrodes and the channel layer may be defined through a single photolithography process and may thus be formed through simple processes. In addition, the source/drain electrodes include a topological metal, and thus, even when the source/drain electrodes are relatively narrow and/or relatively small, issues such as a large voltage drop (IR drop) may be reduced or prevented. Integration of semiconductor devices may be improved by vertically stacking a plurality of transistors in the same area. In this case, source/drain electrodes of an upper transistor and source/drain electrodes of a lower transistor may be simultaneously formed to reduce the number of process operations. The semiconductor devices of the example embodiments described above may be applied to various electronic apparatuses. For example, the semiconductor devices of the example embodiments may form logic circuits in electronic apparatuses. However, example embodiments are not limited thereto.

It should be understood that the example embodiments described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. A semiconductor device comprising:
a first transistor comprising a first channel layer, a first source electrode, and a first drain electrode, the first channel layer comprising a first transition metal dichalcogenide, TMD, material, the first source electrode and the first drain electrode being on the first channel layer; and
a second transistor below the first transistor, the second transistor comprising a second channel layer, a second source electrode, and a second drain electrode, the second channel layer comprising a second TMD material, the second source electrode and the second drain electrode being on the second channel layer,
wherein each of the first source electrode and the first drain electrode comprises a first topological metal comprising at least one element included in the first TMD material, and
each of the second source electrode and the second drain electrode comprises a second topological metal comprising at least one element included in the second TMD material.

2. The semiconductor device of claim 1, wherein the first source electrode and the second source electrode are connected to each other in a vertical direction.

3. The semiconductor device of claim 1 or 2, wherein the first drain electrode and the second drain electrode are connected to each other in a vertical direction.

4. The semiconductor device of one of claims 1 to 3, wherein
the first source electrode and the first drain electrode are on both sides of the first channel layer, respectively, and
the second source electrode and the second drain electrode are on both sides of the second channel layer, respectively,
wherein preferably
each of the first source electrode and the first drain electrode comprises a first interface layer and a first metal layer, the first interface layer being in contact with a lateral surface of the first channel layer and comprising the first topological metal, the first metal layer being on the first interface layer, and
each of the second source electrode and the second drain electrode comprises a second interface layer and a second metal layer, the second interface layer being in contact with a lateral surface of the second channel layer and comprising the second topological metal, the second metal layer being on the second interface layer.

5. The semiconductor device of one of claims 1 to 4, wherein
the first source electrode and the first drain electrode are above both sides of the first channel layer, respectively, and
the second source electrode and the second drain electrode are below both sides of the second channel layer, respectively,
wherein preferably
each of the first source electrode and the first drain electrode comprises a first interface layer and a first metal layer, the first interface layer being in contact with an upper surface of a side of the first channel layer and comprising the first topological metal, the first metal layer being on the first interface layer, and
each of the second source electrode and the second drain electrode comprises a second interface layer and a second metal layer, the second interface layer being in contact with a lower surface of a side of the second channel layer and comprising the second topological metal, the second metal layer being on the second interface layer.

6. The semiconductor device of one of claims 1 to 5, further comprising:
a first via layer electrically connected to each of the first source electrode and the first drain electrode; and
a second via layer electrically connected to each of the second source electrode and the second drain electrode.

7. The semiconductor device of claim 6, wherein
the first via layer comprises the first topological metal, and
the second via layer comprises the second topological metal.

8. The semiconductor device of claim 6, further comprising:
a first interconnect layer electrically connected to the first via layer; and
a second interconnect layer electrically connected to the second via layer.

9. The semiconductor device of claim 8, wherein
the first interconnect layer comprises the first topological metal, and
the second interconnect layer comprises the second topological metal.

10. The semiconductor device of one of claims 1 to 9, wherein
the first transistor is a p-channel metal-oxide semiconductor, PMOS, transistor, and
the second transistor is an n-channel metal-oxide semiconductor, NMOS, transistor.

11. The semiconductor device of one of claims 1 to 10, wherein each of the first and second transistors is a PMOS transistor, or
wherein each of the first and second transistors is an NMOS transistor.

12. The semiconductor device of one of claims 1 to 11, further comprising:
a third transistor below the second transistor, the third transistor comprising a third channel layer, a third source electrode, and a third drain electrode, the third channel layer comprising a third TMD material, the third source electrode and the third drain electrode being on the third channel layer,
wherein each of the third source electrode and the third drain electrode comprises a third topological metal comprising at least one element included in the third TMD material.

13. The semiconductor device of one of claims 1 to 12, wherein an insulating layer is between the first channel layer and the second channel layer, and
preferably further comprising a gate electrode inside the insulating layer.

14. The semiconductor device of one of claims 1 to 13, wherein the first channel layer comprises a plurality of first sub-channel layers provided apart from each other, the second channel layer comprises a plurality of second sub-channel layers provided apart from each other, and a gate electrode surrounds the plurality of first sub-channel layers and the plurality of second sub-channel layers, or
wherein the first source electrode and the first drain electrode are below and above the first channel layer, respectively, and the second source electrode and the second drain electrode are above and below the second channel layer, respectively.

15. An electronic apparatus comprising:
a plurality of semiconductor devices, each of the plurality of semiconductor devices configured according to one of claims 1 to 14.
